(19)

Europäisches Patentamt

European Patent Office

Office européen des brevets

(11) **EP 3 489 706 A1**

(12) **EUROPEAN PATENT APPLICATION**

(43) Date of publication:
**29.05.2019 Bulletin 2019/22**

(51) Int Cl.:
*G01R 33/561* (2006.01)   *G01R 33/36* (2006.01)

(21) Application number: **18205234.0**

(22) Date of filing: **08.11.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **22.11.2017   US 201715820599**

(71) Applicant: **General Electric Company**
**Schenectady, NY 12345 (US)**

(72) Inventors:
 • **CHU, Dashen**
  **Waukesha, WI Wisconsin 53188 (US)**
 • **LI, Zhu**
  **Waukesha, WI Wisconsin 53188-1678 (US)**

 • **ZHENG, Hai**
  **Waukesha, WI Wisconsin 53188-1678 (US)**
 • **KAMMEIER, Anja**
  **Waukesha, WI Wisconsin 53188-1678 (US)**
 • **GUI, Dawei**
  **Waukesha, WI Wisconsin 53188 (US)**
 • **CHANG, Shaorong**
  **Waukesha, WI Wisconsin 53188 (US)**
 • **SLAVENS, Zachary William**
  **Waukesha, WI Wisconsin 53188 (US)**
 • **MCKINNON, Graeme Colin**
  **Waukesha, WI Wisconsin 53188 (US)**

(74) Representative: **Fennell, Gareth Charles et al**
**Kilburn & Strode LLP**
**Lacon London**
**84 Theobalds Road**
**London WC1X 8NL (GB)**

(54) **SYSTEM AND METHOD FOR CHOOSING COIL ELEMENTS FOR PARALLEL MAGNETIC RESONANCE IMAGING BASED ON THE GEOMETRY FACTOR**

(57)    A system 10 for magnetic resonance imaging an object 84 is provided. The system 10 includes a plurality of coil element groupings 124, 126, 128 disposed within one or more RF coils 62, 86, 88, and a controller 36. The controller 36 is operative to receive MR data 74 from the object 84 via the one or more RF coils 62, 86, 88, determine a g-factor for each of the coil element groupings 124, 126, 128 of the plurality based at least in part on the MR data 74, and select a coil element grouping 124, 126, 128 of the plurality based at least in part on the g-factors.

FIG. 6

EP 3 489 706 A1

Printed by Jouve, 75001 PARIS (FR)

**Description**

Embodiments of the invention relate generally to medical imaging systems, and more specifically, to a system and method for magnetic resonance imaging ("MRI") and object.

MRI is a widely accepted and commercially available technique for obtaining digitized visual images representing the internal structure of objects having substantial populations of atomic nuclei that are susceptible to nuclear magnetic resonance ("NMR"). Many MRI systems use superconductive magnets to scan a subject/patient via imposing a strong main magnetic field on the nuclei in the subject to be imaged. The nuclei are excited by a radio frequency ("RF") signal/pulse transmitted by a RF coil at characteristics NMR (Larmor) frequencies. By spatially disturbing localized magnetic fields surrounding the subject and analyzing the resulting RF responses, also referred to hereinafter as the "MR signal," from the nuclei as the excited protons relax back to their lower energy normal state, a map or image of these nuclei responses as a function of their spatial location is generated and displayed. An image of the nuclei responses, also referred to hereinafter as an "MRI image" and/or simply "image," provides a non-invasive view of a subject's internal structure.

Many MRI technologies/approaches are increasingly dependent on RF coil geometry, commonly known as "g-factor", which, as used herein refers to the spatial arrangement of the coil elements forming the RF coil(s) used to transmit/receive the RF pulse/MR signal into/from the subject. As the complexity of RF coil designs continues to advance, however, it is becoming increasingly difficult for technologist to select the most optimal configuration/grouping of coil elements for a particular MRI experiment/scan. Accordingly, many MRI technologies have been developed to assist technologists by automatically selecting coil element groupings for particular MRI scans. One such technology, commonly referred to as MR Imaging-based coil detection, includes various methods of detecting coil element spatial information by measuring the sensitivity of the coil elements within a given region of interest ("ROI"), and then selecting particular coil elements for a grouping based on the contributions of the coil elements to the MR signal within the ROI. Many such methods of MR Imaging-based coil detection, however, are not well suited for use in rapidly changing parallel imaging such as parallel MRI.

In particular, many parallel MRI systems seek to reduce scan time by accelerating a scanning procedure in phase encoding and/or slice direction. As used herein, the term "scan time", refers to the amount of time it takes to complete a MRI scan of a subject, and the term "scan," as used herein, refers to the process of acquiring MR data suitable for an intended purpose, e.g., a medical diagnosis. In many parallel MRI systems, the amount/scale of acceleration possible for a particular scan is typically determined by the geometry and signal to noise ratio ("SNR") of the possible coil element groupings within the one or more RF coils used to conduct the scan. Accordingly, different coil element groupings within the same set of RF coils may yield different accelerations and/or SNRs. Traditionally, technologists manually select a coil element grouping based on a desired acceleration and/or SNR for a particular MRI scan. As stated above, however, in many MRI systems, coil element grouping selection is now performed via MR Imaging-based coil detection methods. Many such MR Imaging-based coil detection methods, however, fail to determine acceleration for potential coil element groupings. Thus, many MRI Imaging-based coil detection methods often select coil element groupings that do not satisfy a technologist's desired acceleration and/or SNR ratio for a particular MRI scan.

What is needed, therefore, is an improved system and method for magnetic resonance imaging an object.

In an embodiment, a system for magnetic resonance imaging an object is provided. The system includes a plurality of coil element groupings disposed within one or more RF coils, and a controller. The controller is operative to receive MR data from the object via the one or more RF coils, determine a g-factor for each of the coil element groupings of the plurality based at least in part on the MR data, and select a coil element grouping of the plurality based at least in part on the g-factors.

In another embodiment, a method for magnetic resonance imaging an object is provided. The method includes receiving MR data from an object via one or more RF coils, determining, based at least in part on the MR data, a g-factor for each of a plurality of coil element groupings disposed within the one or more RF coils, and selecting a coil element grouping of the plurality based at least in part on the g-factors.

In yet another embodiment, a non-transitory computer readable medium that includes instructions is provided. The instructions are configured to adapt a controller to receive MR data from an object via one or more RF coils, and to determine, based at least in part on the MR data, a g-factor for each of a plurality of coil element groupings disposed within the one or more RF coils. The stored instructions are further configured to adapt the controller to select a coil element grouping of the plurality based at least in part on the g-factors.

The present invention will be better understood from reading the following description of non-limiting embodiments, with reference to the attached drawings, wherein below:

FIG. 1 is a block diagram of a system for magnetic resonance imaging an object, in accordance with an embodiment of the present invention;

FIG. 2 is a schematic cross-sectional diagram of a magnet assembly of the system of FIG. 1, in accordance with an embodiment of the present invention;

FIG. 3 is a diagram of MR data acquired by the system of FIG. 1, in accordance with an embodiment of the present invention;

FIG. 4 is a diagram of one or more RF coils of the system of FIG. 1, in accordance with an embodiment of the present invention;

FIG. 5 is another diagram of the one or more RF coils of the system of FIG. 1, in accordance with an embodiment of the present invention; and

FIG. 6 is a flowchart of a method of magnetic resonance imaging an object utilizing the system of FIG. 1, in accordance with an embodiment of the present invention.

Reference will be made below in detail to exemplary embodiments of the invention, examples of which are illustrated in the accompanying drawings. Wherever possible, the same reference characters used throughout the drawings refer to the same or like parts, without duplicative description.

As used herein, the terms "substantially," "generally," and "about" indicate conditions within reasonably achievable manufacturing and assembly tolerances, relative to ideal desired conditions suitable for achieving the functional purpose of a component or assembly. As used herein, "electrically coupled," "electrically connected," and "electrical communication" mean that the referenced elements are directly or indirectly connected such that an electrical current may flow from one to the other. The connection may include a direct conductive connection, i.e., without an intervening capacitive, inductive or active element, an inductive connection, a capacitive connection, and/or any other suitable electrical connection. Intervening components may be present. The term "real-time," as used herein, means a level of processing responsiveness that a user senses as sufficiently immediate or that enables the processor to keep up with an external process. The term "MR data," as used herein, refers to data, e.g., raw K-Space and/or image space, derived from an MR signal.

Further, while the embodiments disclosed herein are described with respect to a parallel MRI system, it is to be understood that embodiments of the present invention may be applicable to other imaging systems to include traditional MRI, UTE MRI, Silent MRI, PET/MRI, and/or any type of MRI based imaging system. Further still, as will be appreciated, embodiments of the present invention related imaging systems may be used to analyze tissue generally and are not limited to human tissue.

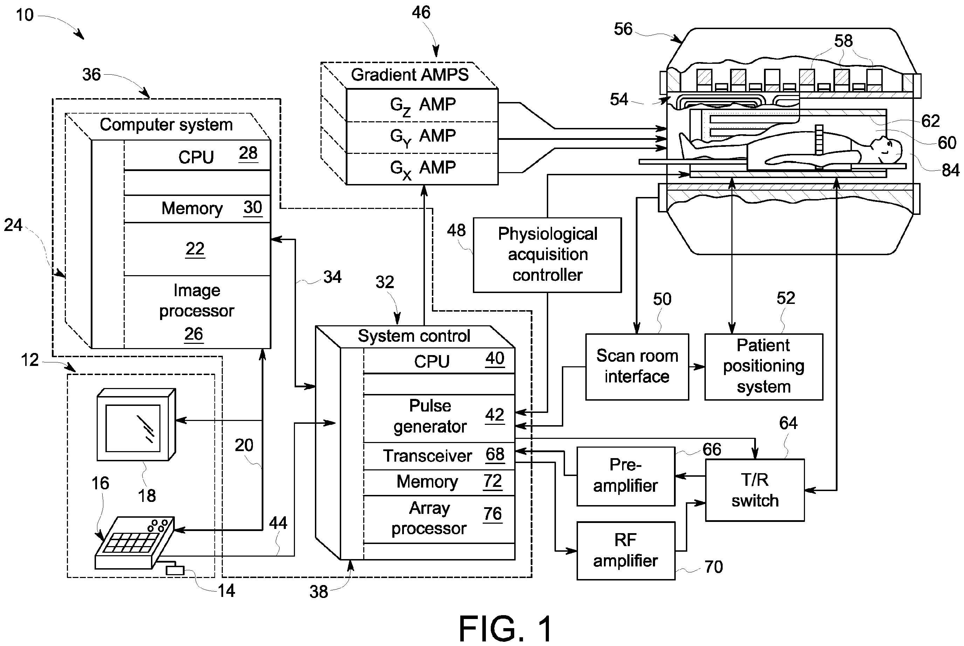

Accordingly, referring now to FIG. 1, the major components of an MRI system 10 incorporating an embodiment of the invention are shown. Operation of the system 10 is controlled from the operator console 12, which includes a keyboard or other input device 14, a control panel 16, and a display screen 18. The console 12 communicates through a link 20 with a separate computer system 22 that enables an operator to control the production and display of images on the display screen 18. The computer system 22 includes a number of modules, which communicate with each other through a backplane 24. These include an image processor module 26, a CPU module 28 and a memory module 30, which may include a frame buffer for storing image data arrays. The computer system 22 communicates with a separate system control or control unit 32 through a high-speed serial link 34. The input device 14 can include a mouse, joystick, keyboard, track ball, touch activated screen, light wand, voice control, or any similar or equivalent input device, and may be used for interactive geometry prescription. The computer system 22 and the MRI system control 32 collectively form an "MRI controller" 36.

The MRI system control 32 includes a set of modules connected together by a backplane 38. These include a CPU module 40 and a pulse generator module 42, which connects to the operator console 12 through a serial link 44. It is through link 44 that the system control 32 receives commands from the operator to indicate the scan sequence that is to be performed. The pulse generator module 42 operates the system components to execute the desired scan sequence and produces data which indicates the timing, strength and shape of the RF pulses produced, and the timing and length of the data acquisition window. The pulse generator module 42 connects to a set of gradient amplifiers 46, to indicate the timing and shape of the gradient pulses that are produced during the scan. The pulse generator module 42 can also receive patient data from a physiological acquisition controller 48 that receives signals from a number of different sensors connected to the patient, such as ECG signals from electrodes attached to the patient. And finally, the pulse generator module 42 connects to a scan room interface circuit 50, which receives signals from various sensors associated with the condition of the patient and the magnet system. It is also through the scan room interface circuit 50 that a patient positioning system 52 receives commands to move the patient to the desired position for the scan.

The pulse generator module 42 operates the gradient amplifiers 46 to achieve desired timing and shape of the gradient pulses that are produced during the scan. The gradient waveforms produced by the pulse generator module 42 are applied to the gradient amplifier system 46 having Gx, Gy, and Gz amplifiers. Each gradient amplifier excites a corresponding physical gradient coil in a gradient coil assembly, generally designated 54, to produce the magnetic field gradients used for spatially encoding acquired signals. The gradient coil assembly 54 forms part of a magnet assembly 56, which also includes a polarizing magnet 58 (which in operation, provides a homogenous longitudinal magnetic field Bo throughout a target volume 60 that is enclosed by the magnet assembly 56) and a whole-body (transmit and receive) RF coil 62 (which, in operation, provides a trans-

verse magnetic field $B_1$ that is generally perpendicular to Bo throughout the target volume 60).

The resulting signals emitted by the excited nuclei in the patient may be sensed by the same RF coil 62 and coupled through the transmit/receive switch 64 to a preamplifier 66. The amplifier MR signals are demodulated, filtered, and digitized in the receiver section of a transceiver 68. The transmit/receive switch 64 is controlled by a signal from the pulse generator module 42 to electrically connect an RF amplifier 70 to the RF coil 62 during the transmit mode and to connect the preamplifier 66 to the RF coil 62 during the receive mode. The transmit/receive switch 64 can also enable a separate RF coil (for example, a surface coil) to be used in either transmit or receive mode.

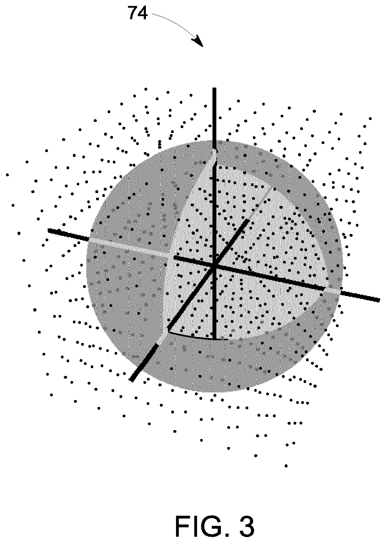

The MR signals picked up by the RF coil 62 are digitized by the transceiver module 68 and transferred to a memory module 72 in the system control 32. A scan is complete when an array of raw K-Space data 74 (FIG. 3) has been acquired in the memory module 72. This raw K-Space data/datum is rearranged into separate K-Space data arrays for each image to be reconstructed, and each of these is input to an array processor 76 which operates to Fourier transform the data into an array of image data. This image data is conveyed through the serial link 34 to the computer system 22 where it is stored in memory 30. In response to commands received from the operator console 12, this image data may be archived in long-term storage or it may be further processed by the image processor 26, conveyed to the operator console 12, and presented on the display 18.

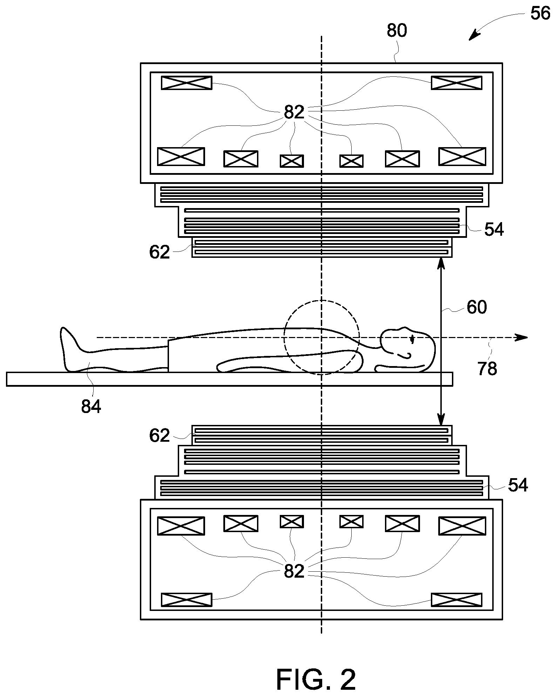

As illustrated in FIG. 2, a schematic side elevation view of the magnet assembly 56 is shown in accordance with an embodiment of the invention. The magnet assembly 56 is cylindrical in shape having a center axis 78. The magnet assembly 56 includes a cryostat 80 and one or more radially aligned longitudinally spaced apart superconductive coils 82 that form the polarizing magnet 58 (FIG. 1). The superconductive coils 82 are capable of carrying large electrical currents and are designed to create the Bo field within the patient/target volume 60. As will be appreciated, the magnet assembly 56 may further include both a terminal shield and a vacuum vessel (not shown) surrounding the cryostat 80 in order to help insulate the cryostat 80 from heat generated by the rest of the MRI system 10 (FIG. 1). The magnet assembly 56 may still further include other elements such as covers, supports, suspension members, end caps, brackets, etc. (not shown). While the embodiment of the magnet assembly 56 shown in FIGS. 1 and 2 utilizes a cylindrical topology, it should be understood that topologies other than cylindrical may be used. For example, a flat geometry in a split-open MRI system may also utilize embodiments of the invention described below. As further shown in FIG. 2, a patient / imaged subject 84 is inserted into the magnet assembly 56.

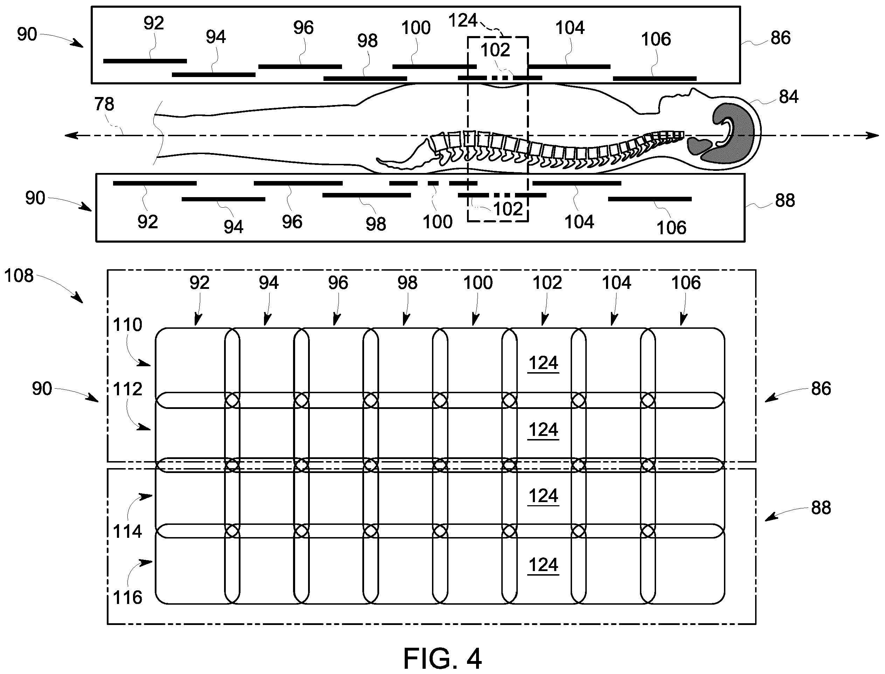

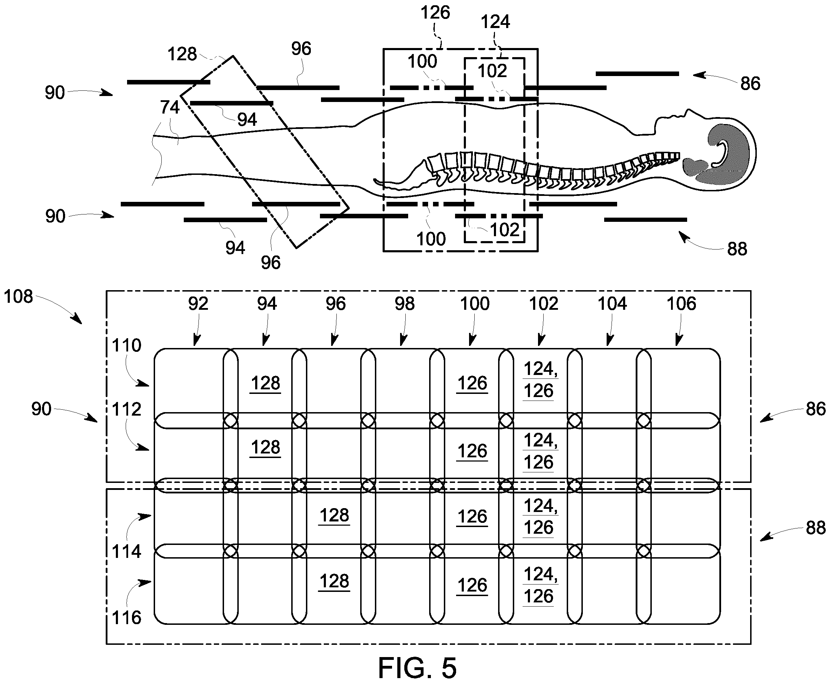

Turning to FIGS. 4 and 5, an embodiment of the system 10 which is configured for performing parallel imaging of the subject 84 via an anterior RF surface coil 86 and a posterior RF surface coil 88 is depicted. As will be understood, while the embodiment shown in FIGS. 4 and 5 includes two RF surface coils 86 and 88 disposed on opposite sides of the subject 84 for parallel imaging, it is to be understood that embodiments of the present invention may be applied to other types of RF coils, to include the whole body coil 62 (FIGS. 1 and 2), e.g., a "birdcage coil", used in parallel imaging and/or other MRI imaging procedures which require and/or benefit from the selection of coil element groupings.

As shown in FIGS. 4 and 5, each of the RF coils 86 and 88 include one or more coil elements 90, which, in embodiments, form tiles 92, 94, 96, 98, 100, 102, 104, 106, i.e., sets of coil elements, generally designated 90, that are disposed so as to cover the same, and/or substantially the same, region of the subject 84 along the axis 78. In embodiments, each tile 92, 94, 96, 98, 100, 102, 104, 106 may include coil elements 90 from different RF coils, e.g., coils 86 and 88. For example, tile 102 may include coil elements from both the anterior 86 and posterior 88 RF coils that are configured to acquire/receive MR data 74 (FIG. 3) from the same region of the subject 84. As will be appreciated, the coil elements 90 and tiles 92, 94, 96, 98, 100, 102, 104, 106 may be represented as a matrix 108 having rows 110, 112, 114, and 116, where rows 110 and 112 represent the coil elements 90 disposed in the anterior coil 86, and where rows 114 and 116 represent the coil elements 90 disposed in the posterior coil 88.

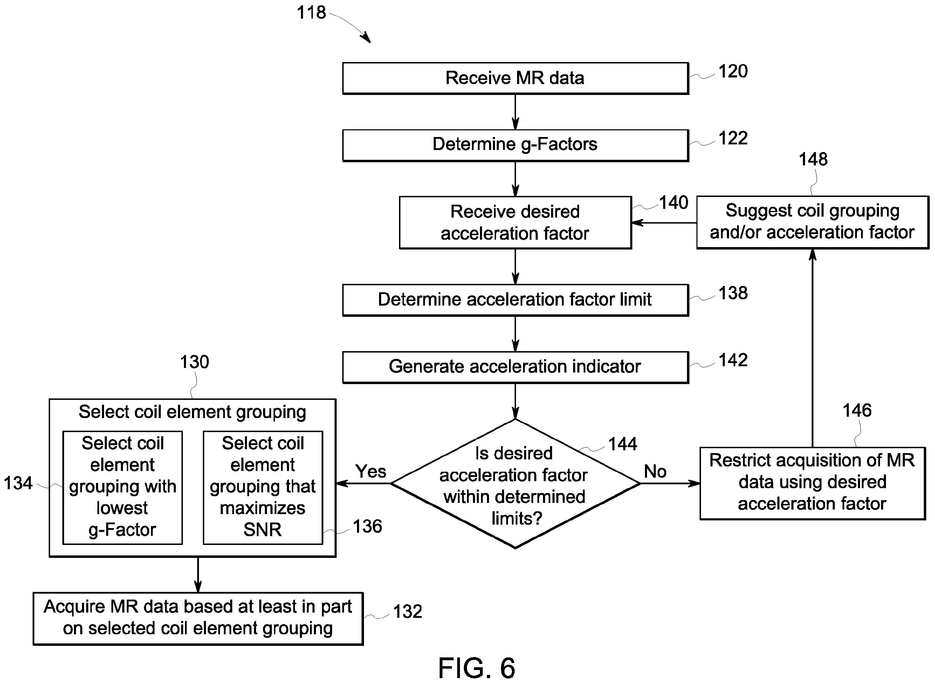

Turning now to FIG. 6, a method 118 of utilizing the system 10 (FIGS. 1-5) in accordance with an embodiment of the present invention is shown. The method 118 includes acquiring/receiving 120 MR data 74 from the subject 84 via one or more of the RF coils 62, 86, and/or 88, determining 122, based at least in part on the MR data 74, a g-factor for each of a plurality of coil elements groupings 124, 126, 128 (FIGS. 4 and 5) within the one or more RF coils 62, 86, and/or 88, and selecting 130 one of the coil element groupings 124, 126, 128 based at least in part on the g-factors. For example, the coil element groupings 124, 126, 128 may be selected based at least in part on a prescribed region of interest, i.e., Rx ROI, of which g-factor may also be dependent on.

In certain aspects, each coil element grouping 124, 126, and 128 may include coil elements 90 from one or more of the tiles 92, 94, 96, 98, 100, 102, 104, 106, as well as from one or more of the RF coils 62, 86, and/or 88. For example, a coil element grouping may include coil elements 90 within: a single tile, e.g., grouping 124 including all coil elements 90 solely within tile 102 as shown in FIG. 4; from multiple tiles, e.g., grouping 126 including all coil elements within tiles 100 and 102 as shown in FIG. 5; or a sub-portion of the coil elements 90 from multiple tiles, e.g., grouping 128 including the anterior coil elements 90 from tile 94 and the posterior coil elements 90 from tile 96 as also shown in FIG. 5. As will be understood, additional coil element groupings are possible. In other words, a coil element grouping may include any possible collection of the available coil elements 90 within the system 10.

In embodiments, the method 118 may further include acquiring 132 additional MR data 74 based at least in part on the selected coil element grouping, e.g., grouping 124. In other words, the first acquisition 120 may be a low resolution and/or calibration scan which allows the system 10 to initially acquire MR data 74 for determining 122 the g-factor for a plurality of possible coil element groupings 124, 126, and 128, and the second acquisition 132 maybe the scan that uses the selected coil element grouping 124, 126, 128 to generate MR data 74 for use in a medical diagnosis.

As will be appreciated, in embodiments, the coil element groupings 124, 126, 128 selected 130 for use in a subsequent acquisition 132 may be selected 130 based at least in part on striking a balance between SNR and a desired acceleration factor. For example, in embodiments configured to perform parallel imaging, the SNR may be modeled by the following equations:

$$SNRpi = \frac{SNRbase}{g} * \sqrt{R}$$

$$g = \sqrt{((S^h N^{-1})^{-1})_{ii}(S^H N^{-1}S)_{ii}}$$

where SNRpi is the SNR in parallel imaging, SNRBase is the SNR without acceleration, R is a scan time reduction factor, N is a noise covariance matrix of a coil array, e.g., the matrix 108 (FIGS. 4 and 5), and S is the sensitivity matrix of coil elements 90 (FIGS. 4 and 5). As will be understood, S may be affected by both the prescriptions of ROI and the selected coil element grouping 124, 126, and/or 128, and the g-factor may increase as R increases, i.e., g=g (ROI, R). As can be seen from the above equations, the g-factor increases exponentially, as opposed to linearly like R, as acceleration goes up. Accordingly, the g-factor typically has a greater impact on the acceleration capability of the MRI system 10 when compared to other contributing factors.

Thus, as shown by boxes 134 and 136 in FIG. 6, in certain aspects, the selected coil element grouping 124, 126, 128 maybe the grouping with the lowest g-factor and/or the grouping that substantially maximizes the SNR of the system 10. As will be further understood, the g-factors may be determined/calculated 122 from sensitivity data, included in the MR data 74 acquired during the first acquisition 120, which corresponds to the one or more RF coils 62, 86, and/or 88. For example, in embodiments, g-factor may be determined 122 from the magnitude and/or phase of the RF signal used to generate the MR data 74. Accordingly, iterations of low-resolution scans 120 (FIG. 6) may be performed to find the minimum g-factor, e.g., the system 10 may repeatedly acquire 120 MR data 74 utilizing different selected coil element groupings and determining a new g-factor after each such acquisition.

In some embodiments, the system 10 may determine 138 and upper limit of the acceleration factor of the system 10 based at least in part on the determined 122 g-factors. For example, in such embodiments, the system 10 may receive 140 a desired acceleration factor, e.g., via an an operator input, for a given scan of a subject 84. Based on the particular RF coils 62, 86, and/or 88 used by the system 10, the desired acceleration factor maybe unattainable and/or may result in noise sufficient to render any images acquired by the system 10 insufficient for their intended use, e.g., medical diagnosis. In other words, an operator may attempt to select a desired acceleration factor and the system 10 may fail to find a coil element grouping 124, 126, 128, from the plurality of possible coil element groupings, that is capable of achieving the desired acceleration factor, i.e., the desired acceleration factor is beyond the capabilities of the MRI system 10. In such situations, the system 10 may determine 138 the maximum acceleration factor which is achievable by the system 10 and likely to result in images acceptable for a medical diagnosis. In such embodiments, the system 10 may generate 142 an audio/visual indicator, e.g., sound(s), LED light(s), GUI message, etc., conveying that the desired acceleration factor is above the determined upper limit. The system 10 may also prevent restrict (represented by boxes 144 and 146) a subsequent acquisition 132 of MR data 74 (FIG. 3) using the desired acceleration factor. As will be appreciated, in some embodiments, the system 10 may suggest 148 a coil element grouping 124, 126, 128 and/or an acceleration factor that is within the capabilities of the system 10 based on the determined g-factors and/or acceleration limit.

Finally, it is also to be understood that the system 10 may include the necessary electronics, software, memory, storage, databases, firmware, logic/state machines, microprocessors, communication links, displays or other visual or audio user interfaces, printing devices, and any other input/output interfaces to perform the functions described herein and/or to achieve the results described herein. For example, as previously mentioned, the system may include at least one processor and system memory / data storage structures, which may include random access memory (RAM) and read-only memory (ROM). The at least one processor of the system 10 may include one or more conventional microprocessors and one or more supplementary co-processors such as math co-processors or the like. The data storage structures discussed herein may include an appropriate combination of magnetic, optical and/or semiconductor memory, and may include, for example, RAM, ROM, flash drive, an optical disc such as a compact disc and/or a hard disk or drive.

Additionally, a software application that adapts the controller to perform the methods disclosed herein may be read into a main memory of the at least one processor from a computer-readable medium. The term "computer-readable medium", as used herein, refers to any medium that provides or participates in providing instructions to the at least one processor of the system 10 (or any other processor of a device described herein) for execution. Such a medium may take many forms, including but not limited to, non-volatile media and volatile media. Non-volatile media include, for example, optical, magnetic, or opto-magnetic disks, such as memory. Volatile media include dynamic random access memory (DRAM), which typically constitutes the main memory. Common forms of computer-readable media include, for example, a floppy disk, a flexible disk, hard disk, magnetic tape, any other magnetic medium, a CD-ROM, DVD, any other optical medium, a RAM, a PROM, an EPROM or EEPROM (electronically erasable programmable read-only memory), a FLASH-EEPROM, any other memory chip or cartridge, or any other medium from which a computer can read.

While in embodiments, the execution of sequences of instructions in the software application causes at least one processor to perform the methods/processes described herein, hard-wired circuitry may be used in place of, or in combination with, software instructions for implementation of the methods/processes of the present invention. Therefore, embodiments of the present invention are not limited to any specific combination of hardware and/or software.

It is further to be understood that the above description is intended to be illustrative, and not restrictive. For example, the above-described embodiments (and/or aspects thereof) may be used in combination with each other. Additionally, many modifications may be made to adapt a particular situation or material to the teachings of the invention without departing from its scope.

For example, in an embodiment, a system for magnetic resonance imaging an object is provided. The system includes a plurality of coil element groupings disposed within one or more RF coils, and a controller. The controller is operative to receive MR data from the object via the one or more RF coils, determine a g-factor for each of the coil element groupings of the plurality based at least in part on the MR data, and select a coil element grouping of the plurality based at least in part on the g-factors. In certain embodiments, the g-factor of the selected coil element grouping is lower than the g-factors for all of the other coil element groupings of the plurality. In certain embodiments, the g-factor of the selected coil element grouping substantially maximizes an acceleration factor of the system. In certain embodiments, the g-factor of the selected coil element grouping substantially maximizes a signal to noise ratio of the system. In certain embodiments, the one or more RF coils are operative to provide for parallel imaging of the object. In certain embodiments, the MR data includes sensitivity data of the one or more RF coils. In certain embodiments, the sensitivity data is based at least in part on at least one of an RF signal magnitude, and an RF signal phase. In certain embodiments, the controller is further operative to determine an upper limit for an acceleration factor of the system based at least in part on the g-factors.

Yet other embodiments provide a method for magnetic resonance imaging an object. The method includes receiving MR data from an object via one or more RF coils, determining, based at least in part on the MR data, a g-factor for each of a plurality of coil element groupings disposed within the one or more RF coils, and selecting a coil element grouping of the plurality based at least in part on the g-factors. In certain embodiments, selecting a coil element grouping of the plurality based at least in part on the g-factors includes determining which coil element grouping of the plurality has the lowest g-factor. In certain embodiments, selecting a coil element grouping of the plurality based at least in part on the g-factors includes determining which coil element grouping of the plurality substantially maximizes an acceleration factor of a magnetic resonance imaging system that includes the one or more RF coils. In certain embodiments, selecting a coil element grouping of the plurality based at least in part on the g-factors includes determining which coil element grouping of the plurality substantially maximizes a signal to noise ratio of a magnetic resonance imaging system that includes the one or more RF coils. In certain embodiments, the MR data is generated via parallel imaging the object via the one or more RF coils. In certain embodiments, the MR data includes sensitivity data of the one or more RF coils. In certain embodiments, the sensitivity data is based at least in part on at least one of an RF signal magnitude, and an RF signal phase. In certain embodiments, the method further includes determining, based at least in part on the g-factors, an upper limit for an acceleration factor of a magnetic resonance imaging system that includes the one or more RF coils.

Yet still other embodiments provide for a non-transitory computer readable medium that includes instructions. The instructions are configured to adapt a controller to receive MR data from an object via one or more RF coils, to determine, based at least in part on the MR data, a g-factor for each of a plurality of coil element groupings disposed within the one or more RF coils, and to select a coil element grouping of the plurality based at least in part on the g-factors. In certain embodiments, the instructions are further configured to adapt the controller to determine which coil element grouping of the plurality has the lowest g-factor. In certain embodiments, the stored instructions are further configured to adapt the controller to determine which coil element grouping of the plurality substantially maximizes an acceleration factor of a magnetic resonance imaging system that includes the one or more RF coils. In certain embodiments, the stored instructions are further configured to adapt the controller to determine which coil element grouping of the plurality substantially maximizes a signal to noise ratio of a magnetic resonance imaging system that includes the one or more RF coils.

Accordingly, by exploring/analyzing information, e.g., MR data, from a calibration scan, some embodiments of the present invention may provide for improved selection of coil element groupings for a given ROI, as well as improved selection of acceleration factors based on the available coil element groupings for a particular MRI scan. Thus, some embodiments of the present invention provide for an improved system and method of selecting a coil element grouping in parallel imaging MRI systems.

As will be further appreciated, some embodiments of the present invention may improve throughput of parallel imaging workflows by eliminating the trial and error process of coil element grouping selection and acceleration prescriptions, that is typically associated with traditional parallel imaging systems.

Additionally, while the dimensions and types of materials described herein are intended to define the parameters of the invention, they are by no means limiting and are exemplary embodiments. Many other embodiments will be apparent to those of skill in the art upon reviewing the above description. The scope of the invention should, therefore, be determined with reference to the appended claims, along with the full scope of equivalents to which such claims are entitled. In the appended claims, the terms "including" and "in which" are used as the plain-English equivalents of the respective terms "comprising" and "wherein." Moreover, in the following claims, terms such as "first," "second," "third," "upper," "lower," "bottom," "top," etc. are used merely as labels, and are not intended to impose numerical or positional requirements on their objects. Further, the limitations of the following claims are not written in means-plus-function format are not intended to be interpreted as such, unless and until such claim limitations expressly use the phrase "means for" followed by a statement of function void of further structure.

This written description uses examples to disclose several embodiments of the invention, including the preferred mode, and also to enable one of ordinary skill in the art to practice the embodiments of invention, including making and using any devices or systems and performing any incorporated methods. The patentable scope of the invention is defined by the claims, and may include other examples that occur to one of ordinary skill in the art. Such other examples are intended to be within the scope of the claims if they have structural elements that do not differ from the literal language of the claims, or if they include equivalent structural elements with insubstantial differences from the literal languages of the claims.

As used herein, an element or step recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising," "including," or "having" an element or a plurality of elements having a particular property may include additional such elements not having that property.

Since certain changes may be made in the above-described invention, without departing from the spirit and scope of the invention herein involved, it is intended that all of the subject matter of the above description shown in the accompanying drawings shall be interpreted merely as examples illustrating the inventive concept herein and shall not be construed as limiting the invention.

Various aspects and embodiments of the present invention are defined by the following numbered clauses:

1. A system for magnetic resonance imaging an object comprising:

a plurality of coil element groupings disposed within one or more RF coils; and
a controller operative to:

receive MR data from the object via the one or more RF coils;
determine a g-factor for each of the coil element groupings of the plurality based at least in part on the MR data; and
select a coil element grouping of the plurality based at least in part on the g-factors.

2. The system of clause 1, wherein the g-factor of the selected coil element grouping is lower than the g-factors for all of the other coil element groupings of the plurality.

3. The system of any preceding clause, wherein the g-factor of the selected coil element grouping substantially maximizes an acceleration factor of the system.

4. The system of any preceding clause, wherein the g-factor of the selected coil element grouping substantially maximizes a signal to noise ratio of the system.

5. The system of any preceding clause, wherein the one or more RF coils are operative to provide for parallel imaging of the object.

6. The system of any preceding clause, wherein the MR data includes sensitivity data of the one or more RF coils.

7. The system of any preceding clause, wherein the sensitivity data is based at least in part on at least one of:

an RF signal magnitude; and
an RF signal phase.

8. The system of any preceding clause, wherein the controller is further operative to:

determine an upper limit for an acceleration factor of the system based at least in part on the g-factors.

9. A method for magnetic resonance imaging an object comprising:

receiving MR data from an object via one or more RF coils;
determining, based at least in part on the MR data, a g-factor for each of a plurality of coil element groupings disposed within the one or more RF coils; and
selecting a coil element grouping of the plurality based at least in part on the g-factors.

10. The method of any preceding clause, wherein selecting a coil element grouping of the plurality based at least in part on the g-factors comprises: determining which coil element grouping of the plurality has the lowest g-factor.

11. The method of any preceding clause, wherein selecting a coil element grouping of the plurality based at least in part on the g-factors comprises: determining which coil element grouping of the plurality substantially maximizes an acceleration factor of a magnetic resonance imaging system that includes the one or more RF coils.

12. The method of any preceding clause, wherein selecting a coil element grouping of the plurality based at least in part on the g-factors comprises: determining which coil element grouping of the plurality substantially maximizes a signal to noise ratio of a magnetic resonance imaging system that includes the one or more RF coils.

13. The method of any preceding clause, wherein the MR data is generated via parallel imaging the object via the one or more RF coils.

14. The method of any preceding clause, wherein the MR data includes sensitivity data of the one or more RF coils.

15. The method of any preceding clause, wherein the sensitivity data is based at least in part on at least one of:

an RF signal magnitude; and
an RF signal phase.

16. The method of any preceding clause further comprising:
determining, based at least in part on the g-factors, an upper limit for an acceleration factor of a magnetic resonance imaging system that includes the one or more RF coils.

17. A non-transitory computer readable medium comprising instructions configured to adapt a controller to:
receive MR data from an object via one or more RF coils;
determine, based at least in part on the MR data, a g-factor for each of a plurality of coil element groupings disposed within the one or more RF coils; and
select a coil element grouping of the plurality based at least in part on the g-factors.

18. The non-transitory computer readable medium of any preceding clause, wherein the instructions are further configured to adapt the controller to:
determine which coil element grouping of the plurality has the lowest g-factor.

19. The non-transitory computer readable medium of any preceding clause, wherein the instructions are further configured to adapt the controller to:
determine which coil element grouping of the plurality substantially maximizes an acceleration factor of a magnetic resonance imaging system that includes the one or more RF coils.

20. The non-transitory computer readable medium of any preceding clause, wherein the instructions are further configured to adapt the controller to:
determine which coil element grouping of the plurality substantially maximizes a signal to noise ratio of a magnetic resonance imaging system that includes the one or more RF coils.

**Claims**

1.  A system (10) for magnetic resonance imaging an object (84) comprising:

a plurality of coil element groupings (124, 126, 128) disposed within one or more RF coils (62, 86, 88); and
a controller (36) operative to:

receive MR data (74) from the object (84) via the one or more RF coils (62, 86, 88);
determine a g-factor for each of the coil element groupings (124, 126, 128) of the plurality based at least in part on the MR data (74); and
select a coil element grouping (124, 126, 128) of the plurality based at least in part on the g-factors.

2. The system (10) of claim 1, wherein the g-factor of the selected coil element grouping (124, 126, 128) is lower than the g-factors for all of the other coil element groupings (124, 126, 128) of the plurality.

3. The system (10) of any preceding claim, wherein the g-factor of the selected coil element grouping (124, 126, 128) substantially maximizes an acceleration factor of the system (10).

4. The system (10) of any preceding claim, wherein the g-factor of the selected coil element grouping (124, 126, 128) substantially maximizes a signal to noise ratio of the system (10).

5. The system (10) of any preceding claim, wherein the one or more RF coils (62, 86, 88) are operative to provide for parallel imaging of the object 84.

6. The system (10) of any preceding claim, wherein the MR data (74) includes sensitivity data of the one or more RF coils (62, 86, 88).

7. The system (10) of claim 6, wherein the sensitivity data is based at least in part on at least one of:

an RF signal magnitude; and
an RF signal phase.

8. The system (10) of any preceding claim, wherein the controller (36) is further operative to:

determine an upper limit for an acceleration factor of the system (10) based at least in part on the g-factors.

9. A method (118) for magnetic resonance imaging an object (84) comprising:

receiving (120) MR data (74) from the object (84) via one or more RF coils (62, 86, 88);
determining (122), based at least in part on the MR data (74), a g-factor for each of a plurality of coil element groupings (124, 126, 128) disposed within the one or more RF coils (62, 86, 88); and
selecting (130) a coil element grouping (124, 126, 128) of the plurality based at least in part on the g-factors.

10. The method (118) of claim 9, wherein selecting (130) a coil element grouping (124, 126, 128) of the plurality based at least in part on the g-factors comprises:

determining (134) which coil element grouping (124, 126, 128) of the plurality has the lowest g-factor.

11. The method (118) of claim 9 or 10, wherein selecting (130) a coil element grouping (124, 126, 128) of the plurality based at least in part on the g-factors comprises:

determining which coil element grouping (124, 126, 128) of the plurality substantially maximizes an acceleration factor of a magnetic resonance imaging system 10 that includes the one or more RF coils (62, 86, 88).

12. The method (118) of any of claims 9 to 11, wherein selecting (130) a coil element grouping (124, 126, 128) of the plurality based at least in part on the g-factors comprises:

determining (136) which coil element grouping (124, 126, 128) of the plurality substantially maximizes a signal to noise ratio of a magnetic resonance imaging system (10) that includes the one or more RF coils (62, 86, 88).

13. The method (118) of any of claims 9 to 12, wherein the MR data (74) is generated via parallel imaging the object (84) via the one or more RF coils (62, 86, 88).

14. The method (118) of any of claims 9 to 13, wherein the MR data (74) includes sensitivity data of the one or more RF coils (62, 86, 88).

15. The method (118) of claim 14, wherein the sensitivity data is based at least in part on at least one of:

an RF signal magnitude; and
an RF signal phase.

FIG. 1

FIG. 2

74

FIG. 3

FIG. 4

FIG. 5

FIG. 6

Europäisches
Patentamt

European
Patent Office

Office européen
des brevets

# EUROPEAN SEARCH REPORT

**Application Number**

EP 18 20 5234

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 319 957 A1 (TOSHIBA KK [JP]) 18 June 2003 (2003-06-18) * paragraph [0195] - paragraph [0196] * * figures 8,9,25 * | 1-15 | INV. G01R33/561 G01R33/36 |
| X | MULLER S ET AL: "Dynamic coil selection for real-time imaging in interventional MRI", MAGNETIC RESONANCE IN MEDIC, JOHN WILEY & SONS, INC, US, vol. 56, no. 5, 1 November 2006 (2006-11-01), pages 1156-1162, XP007909338, ISSN: 0740-3194, DOI: 10.1002/MRM.21028 * Abstract * * section "MATERIALS AND METHODS" * * page 1162 * | 1-15 | |
| X | US 2006/006867 A1 (VAN DEN BRINK JOHAN S [NL]) 12 January 2006 (2006-01-12) * paragraph [0029] * | 1-15 | |
| | | | TECHNICAL FIELDS SEARCHED (IPC) |
| A | DAVID J LARKMAN ET AL: "INVITED TOPICAL REVIEW; Parallel magnetic resonance imaging", PHYSICS IN MEDICINE AND BIOLOGY, INSTITUTE OF PHYSICS PUBLISHING, BRISTOL GB, vol. 52, no. 7, 7 April 2007 (2007-04-07), pages R15-R55, XP020113275, ISSN: 0031-9155, DOI: 10.1088/0031-9155/52/7/R01 * section "3.2. Intrinsic limits" * | 1-15 | G01R |

The present search report has been drawn up for all claims

| Place of search | Date of completion of the search | Examiner |
|---|---|---|
| Munich | 5 April 2019 | Durst, Markus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 20 5234

This annex lists the patent family members relating to the patent documents cited in the above-mentioned European search report.
The members are as contained in the European Patent Office EDP file on
The European Patent Office is in no way liable for these particulars which are merely given for the purpose of information.

05-04-2019

| Patent document cited in search report | | Publication date | Patent family member(s) | | Publication date |
|---|---|---|---|---|---|
| EP 1319957 | A1 | 18-06-2003 | CN | 1450358 A | 22-10-2003 |
| | | | CN | 101078753 A | 28-11-2007 |
| | | | DE | 60224867 T2 | 22-01-2009 |
| | | | EP | 1319957 A1 | 18-06-2003 |
| | | | EP | 1770407 A1 | 04-04-2007 |
| | | | JP | 3455530 B1 | 14-10-2003 |
| | | | JP | 2003334177 A | 25-11-2003 |
| | | | US | 2003132750 A1 | 17-07-2003 |
| | | | US | 2006087320 A1 | 27-04-2006 |
| US 2006006867 | A1 | 12-01-2006 | AU | 2003233130 A1 | 06-01-2004 |
| | | | CN | 1662824 A | 31-08-2005 |
| | | | EP | 1518129 A1 | 30-03-2005 |
| | | | JP | 2005529705 A | 06-10-2005 |
| | | | US | 2006006867 A1 | 12-01-2006 |
| | | | WO | 2004001435 A1 | 31-12-2003 |

EPO FORM P0459

For more details about this annex : see Official Journal of the European Patent Office, No. 12/82